# EUROPEAN PATENT APPLICATION

(11) **EP 4 686 108 A1**
(43) Date of publication of application: **28.01.2026**
(21) Application number: 24190562.9
(22) Date of filing: 24.07.2024
(51) Int. Cl.: H04B 5/26, H04B 5/43, H04B 5/79

(54) **NFC DEVICE AND IMPLEMENTING METHOD THEREOF**

(71) Applicant: NXP B.V., 5656 AG Eindhoven (NL)
(72) Inventor: Haslinger, Dorian, 5656AG Eindhoven (NL); Neophytou, Kyriakos, 5656AG Eindhoven (NL); Liebisch, Gregor, 5656AG Eindhoven (NL)
(74) Representative: Krott, Michel

(57) **Abstract**

In accordance with a first aspect of the present disclosure, a near field communication (NFC) device is provided, comprising: an NFC circuit; a matching circuit operatively coupled to the NFC circuit; a first antenna and a second antenna; a first switch operable in a first state and in a second state, said first switch being configured to connect a first end of the first antenna to a first end of the second antenna when operated in the first state, and to connect said first end of the first antenna to the matching circuit when operated in the second state. In accordance with a second aspect of the present disclosure, a corresponding method of implementing a near field communication (NFC) device is conceived.

## Description

### TECHNICAL FIELD

The present disclosure relates to a near field communication (NFC) device. Furthermore, the present disclosure relates to a corresponding method of implementing an NFC device.

### BACKGROUND

NFC devices for wireless charging applications face different challenges than NFC devices for typical NFC applications, such as contactless transactions. For example, vehicles may be equipped with a dual Qi-based wireless charger. In such a case, an NFC device may be used to detect objects in the proximity of the dual charger. For this purpose, the NFC device typically includes at least two NFC antennas. In that case, it may be difficult keep the power consumption and complexity of the NFC device at an acceptable level.

### SUMMARY

In accordance with a first aspect of the present disclosure, a near field communication (NFC) device is provided, comprising: an NFC circuit; a matching circuit operatively coupled to the NFC circuit; a first antenna and a second antenna; a first switch operable in a first state and in a second state, said first switch being configured to connect a first end of the first antenna to a first end of the second antenna when operated in the first state, and to connect said first end of the first antenna to the matching circuit when operated in the second state.

In one or more embodiments, the NFC device further comprises a tuning capacitor coupled between the first end of the first antenna and the first end of the second antenna, such that the first antenna is matched with the second antenna when the first switch is operated in the first state.

In one or more embodiments, the NFC device further comprises a second switch operable in a first state and in a second state, said second switch being configured to connect a second end of the first antenna to the matching circuit when operated in the first state, and to connect the first switch to the matching circuit when operated in the second state.

In one or more embodiments, the NFC device further comprises a third switch operable in a first state and in a second state, said third switch being configured to connect a second end of the second antenna to the matching circuit when operated in the first state, and to connect the first end of the first antenna to the matching circuit when operated in the second state.

In one or more embodiments, the NFC device further comprises a switching controller configured to control the first switch, the second switch and the third switch in such a way that the second switch is operated in the first state and the third switch is operated in the first state when the first switch is operated in the first state.

In one or more embodiments, the switching controller is further configured to control the first switch, the second switch and the third switch in such a way that the second switch and the third switch together alternately connect the first antenna and the second antenna to the matching circuit when the first switch is operated in the first state.

In one or more embodiments, the NFC device further comprises a main controller configured to measure a first load on the first antenna and a second load on the second antenna, and to select either the first antenna or the second antenna for performing NFC operations in dependence on the measured first load and second load.

In one or more embodiments, the main controller is configured to select the first antenna if the first load is higher than the second load, and to select the second antenna if the second load is higher than the first load.

In one or more embodiments, a charging device comprises an NFC device of the kind set forth.

In one or more embodiments, the charging device is a Qi-based charging device.

In accordance with a second aspect of the present disclosure, a method of implementing a near field communication (NFC) device is conceived, comprising: providing the NFC device with an NFC circuit; providing the NFC device with a matching circuit operatively coupled to the NFC circuit; providing the NFC device with a first antenna and a second antenna; providing the NFC device with a first switch operable in a first state and in a second state, said first switch being configured to connect a first end of the first antenna to a first end of the second antenna when operated in the first state, and to connect said first end of the first antenna to the matching circuit when operated in the second state.

In one or more embodiments, the method further comprises providing the NFC device with a tuning capacitor coupled between the first end of the first antenna and the first end of the second antenna, such that the first antenna is matched with the second antenna when the first switch is operated in the first state.

In one or more embodiments, the method further comprises providing the NFC device with a second switch operable in a first state and in a second state, said second switch being configured to connect a second end of the first antenna to the matching circuit when operated in the first state, and to connect the first switch to the matching circuit when operated in the second state.

In one or more embodiments, the method further comprises providing the NFC device with a third switch operable in a first state and in a second state, said third switch being configured to connect a second end of the second antenna to the matching circuit when operated in the first state, and to connect the first end of the first antenna to the matching circuit when operated in the second state.

In one or more embodiments, the method further comprises providing the NFC device with a switching controller configured to control the first switch, the second switch and the third switch in such a way that the second switch is operated in the first state and the third switch is operated in the first state when the first switch is operated in the first state.

### DESCRIPTION OF DRAWINGS

Embodiments will be described in more detail with reference to the appended drawings.
Fig. 1 shows an example of an NFC device.
Fig. 2 shows an example of a method of operating an NFC device.
Fig. 3 shows an illustrative embodiment of an NFC device.
Fig. 4 shows an illustrative embodiment of a method of implementing an NFC device.
Fig. 5 shows another illustrative embodiment of an NFC device.
Fig. 6 shows an illustrative embodiment of a method of operating an NFC device.

### DESCRIPTION OF EMBODIMENTS

As mentioned above, a typical NFC device for wireless charging applications uses at least two antennas. Such a dual NFC-antenna solution, which is often used in automotive applications for object detection on the surface of a wireless charger (Qi system), should apply a differential driver concept due to meet given radio frequency (RF) requirements. However, NFC integrated circuits (ICs) typically support only one differential driver. To avoid the complexity and cost of using two NFC ICs, switches may be used to multiplex the driver signal. However, to perform antenna multiplexing a host controller should switch between the first antenna and the second antenna, which often results in a high dark current consumption and additional traffic on the host controller.

Today, most vehicle manufacturers are implementing dual Qi-charger solutions, instead of single Qi-charger solutions. In parallel, low-power requirements are also becoming more important for wireless chargers operating in the detection mode. Therefore, NFC-based (ultra-)low-power card detection - referred to as (u)LPCD - methods are typically used to enable a reliable object detection and to keep the power consumption at a very low level. However, if multiple antennas are used, existing NFC-based detection methods may be limited by a poor RF performance (in case of a single-ended implementation) or may result in a high power consumption due to the host controller, which may need to stay active and switch between the antennas.

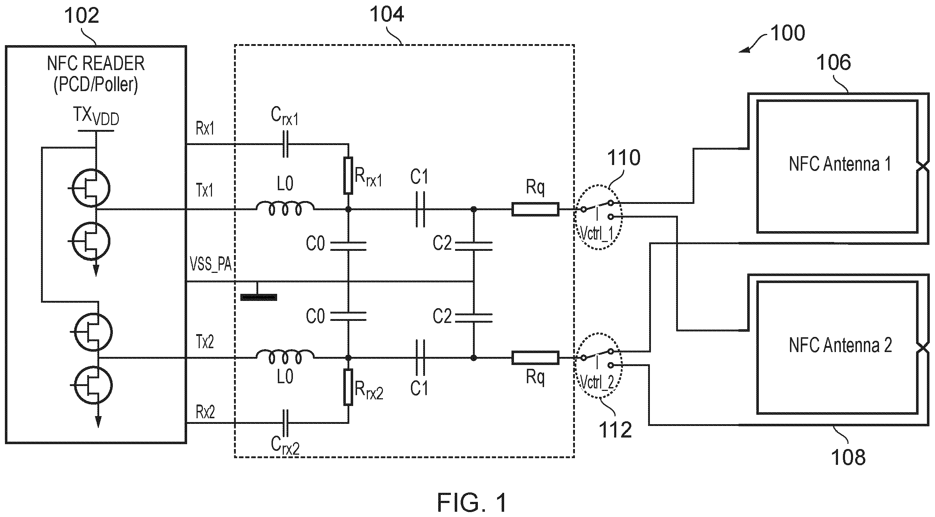

Fig. 1 shows an example of an NFC device 100. A dual-antenna NFC device, which is based on a single NFC IC, may be implemented in different ways. In one implementation, two single-ended antennas may be connected to each transmitter (TX) pin of the NFC IC. However, this implementation has the disadvantage that the generated magnetic field may be weak, because only TX is utilized for both antennas. Therefore, this implementation is not suitable for Qi-charger installed in a vehicle, for example. In another implementation, a pair of high frequency (HF) switches may be used to switch between two antennas. This implementation is shown in Fig. 1.

The NFC device 100 comprises an NFC IC of the kind set forth, more specifically an NFC reader IC 102, which may also be referred to as a proximity coupling device (PCD) or "Poller". Furthermore, the NFC device 100 comprises an impedance matching circuit 104 (referred to in short as a matching circuit), two NFC antennas 106, 108, and a pair of switches 110, 112. As mentioned above, the switches 110, 112 may be used to switch between the two antennas 106, 108. This implementation has a high complexity, because a microcontroller (not shown) should switch between the two antennas, by executing (u)LPCD operations using one antenna at a time. It is noted that the switches 110, 112 may be controlled by said microcontroller using control signals *Vctrl_1* and *Vctrl_2.*

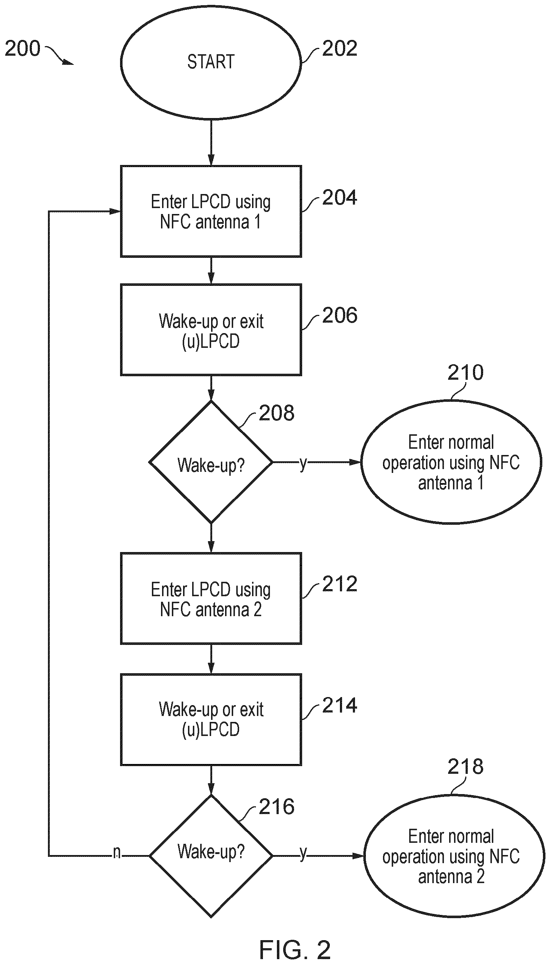

Fig. 2 shows an example of a method 200 of operating an NFC device. In particular, a method 200 of operating the NFC device of Fig. 1 is shown. The method 200 includes, after starting 202, executing 204 a (u)LCPD process using a first NFC antenna, and subsequently deciding 206 to wake up the NFC device (i.e., if an object has been detected in its proximity) or to exit the (u)LCPD process. If a wake-up is performed, normal operation using the first NFC antenna is entered 210. Otherwise, a (u)LCPD process is executed 212 using a second NFC antenna, and subsequently it is decided 214 to wake up the NFC device (i.e., if an object has been detected in its proximity) or to exit the (u)LCPD process. If a wake-up is performed, normal operation using the second NFC antenna is entered 218. Otherwise, the method 200 returns to step 204. As can be seen, the implementation shown in Fig. 1 results in a relatively complex method 200, which also introduces an overhead on the microcontroller.

Now discussed is an NFC device which facilitates reducing the complexity of NFC-based detection methods that make use of multiple NFC antennas and a single NFC IC. Furthermore, a corresponding method of implementing an NFC device is discussed. The NFC device may be integrated into a charging device, for example into a Qi-based charging device. The NFC device may also be integrated into other types of devices that should be able to execute a reliable and relatively simple object detection method. It is noted that the NFC circuit of the NFC device is typically used for detecting an external device that should be charged. The charging itself may be carried out using a low frequency (LF) power transmitter configured to transfer power to the external device, for example a Qi-based LF power transmitter. Alternatively, the NFC circuit may also be used to charge the external device.

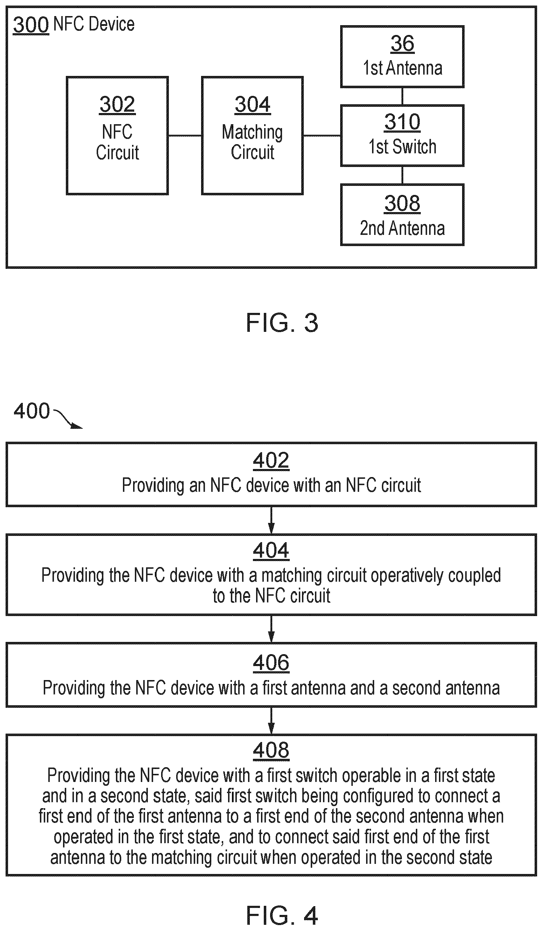

**Fig. 3** shows an illustrative embodiment of an NFC device 300. The NFC device 300 comprises an NFC circuit 302 (i.e., an NFC IC of the kind set forth), a matching circuit 304, a first antenna 306, a second antenna 308, and a first switch 310. The first switch 310 is operable in a first state and in a second state. More specifically, the first switch 310 is configured to connect a first end of the first antenna 306 to a first end of the second antenna 308 when operated in the first state, and to connect said first end of the first antenna 306 to the matching circuit 304 when operated in the second state. By providing the NFC device 300 with the first switch, the two antennas 306, 308 can be connected in series to the matching circuit 304 and the NFC circuit 302 (i.e., when the first switch 310 is operated in the first state), while the two antennas 306, 308 may also remain disconnected from each other (i.e., when the first switch is operated in the second state). Thus, in this way, a single NFC IC may easily be connected to multiple antennas simultaneously. This, in turn, may reduce the complexity of NFC-based detection methods, because no complex procedure for antenna switching needs to be implemented by a microcontroller.

In one or more embodiments, the NFC device further comprises a tuning capacitor coupled between the first end of the first antenna and the first end of the second antenna, such that the first antenna is matched with the second antenna when the first switch is operated in the first state. Thus, the tuning capacitor may ensure that the two antennas are matched when they are connected in series. In one or more embodiments, the NFC device further comprises a second switch operable in a first state and in a second state, said second switch being configured to connect a second end of the first antenna to the matching circuit when operated in the first state, and to connect the first switch to the matching circuit when operated in the second state. In this way, placing the two antennas in a series connection is facilitated. In one or more embodiments, the NFC device further comprises a third switch operable in a first state and in a second state, said third switch being configured to connect a second end of the second antenna to the matching circuit when operated in the first state, and to connect the first end of the first antenna to the matching circuit when operated in the second state. In this way, placing the two antennas in a series connection is further facilitated.

In one or more embodiments, the NFC device further comprises a switching controller configured to control the first switch, the second switch and the third switch in such a way that the second switch is operated in the first state and the third switch is operated in the first state when the first switch is operated in the first state. This results in a practical implementation of the switch control, in order to easily place the two antennas in a series connection. In one or more embodiments, the switching controller is further configured to control the first switch, the second switch and the third switch in such a way that the second switch and the third switch together alternately connect the first antenna and the second antenna to the matching circuit when the first switch is operated in the first state. This results in a practical implementation of the switch control, in order to easily place the two antennas back in their original configuration, according to which they may connected separately to the matching circuit in an alternating manner.

In one or more embodiments, the NFC device further comprises a main controller configured to measure a first load on the first antenna and a second load on the second antenna, and to select either the first antenna or the second antenna for performing NFC operations in dependence on the measured first load and second load. In this way, the selection of a suitable antenna for performing subsequent operations is facilitated. In a practical implementation, the main controller is configured to select the first antenna if the first load is higher than the second load, and to select the second antenna if the second load is higher than the first load.

**Fig. 4** shows an illustrative embodiment of a method 400 of implementing an NFC device. The method 400 comprises the following steps. At 402, an NFC device is provided 402 with an NFC circuit. At 404, the NFC device is provided with a matching circuit operatively coupled to the NFC circuit. At 406, the NFC device is provided with a first antenna and a second antenna. Furthermore, at 408, the NFC device is provided with a first switch operable in a first state and in a second state, said first switch being configured to connect a first end of the first antenna to a first end of the second antenna when operated in the first state, and to connect said first end of the first antenna to the matching circuit when operated in the second state. As explained with reference to the corresponding NFC device shown in Fig. 1, the method 400 facilitates reducing the complexity of NFC-based detection methods, because no complex procedure for antenna switching needs to be implemented by a microcontroller.

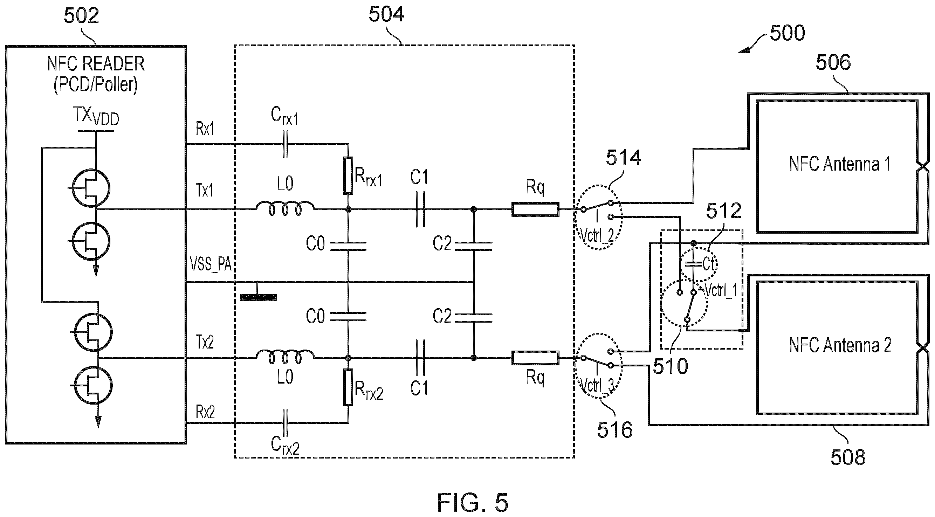

**Fig. 5** shows another illustrative embodiment of an NFC device 500. In particular, an example is shown of an implementation of the presently disclosed NFC device. The NFC device 500 comprises an NFC IC of the kind set forth, more specifically an NFC reader IC 502, which may also be referred to as a proximity coupling device (PCD) or "Poller". Furthermore, the NFC device 500 comprises a matching circuit 504 and two NFC antennas 506, 508. In addition, the NFC device 500 comprises a first switch 510 and a tuning capacitor 512, which are placed between the two antennas 506, 508. Using this first switch 510, the two antennas 506, 508 can be connected in series. Furthermore, the tuning capacitor 512 may ensure that the antennas 506, 508 are matched when they are connected in series. Furthermore, the NFC device 500 comprises a second switch 514 and a third switch 516, which correspond to the pair of switches of the NFC device shown in Fig. 1. The switches 510, 514, 516 may be controlled by a microcontroller (not shown), i.e., by a switching controller of the kind set forth, using control signals *Vctrl_1, Vctrl_*2 and *Vctrl_3.*

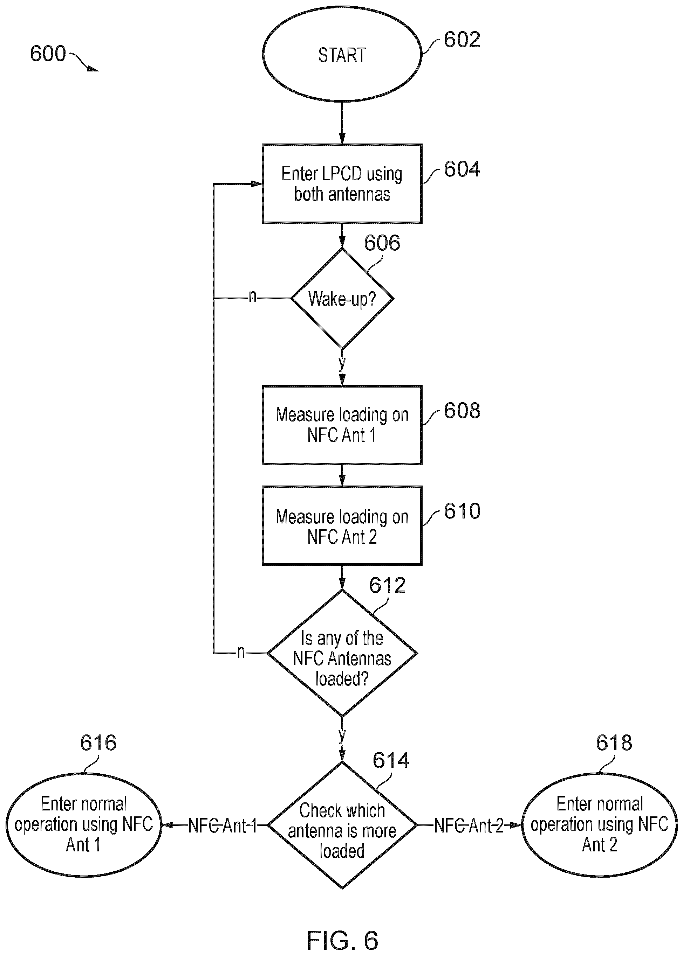

**Fig. 6** shows an illustrative embodiment of a method 600 of operating an NFC device. In particular, a method 600 of operating the NFC device of Fig. 5 is shown. The method 600 includes, after starting 602, entering 604 (i.e., executing) a (u)LPCD process using both antennas. If the (u)LPCD process concludes that a wake-up 606 is needed, then the loading on the first NFC antenna is measured 608, and the loading on the second NFC antenna is measured 610. Otherwise, the method 600 returns to step 604. If it is concluded, at step 612, that any one of the two NFC antennas is loaded, then a check is performed 614 as to which antenna is more loaded. If the first NFC antenna is more loaded than the second NFC antenna, then normal operation is entered 616 using the first NFC antenna. If the second NFC antenna is more loaded than the first NFC antenna, then normal operation is entered 616 using the second NFC antenna. Finally, if it is concluded, at step 612, that none of the two NFC antennas is loaded, then the method 600 returns to step 604. Since the (u)LPCD process can be executed using both antennas connected in series, the method 600 is relatively simple and the overhead on the microcontroller may be reduced. The measuring of the loading on the antennas are additional, optional steps, which implement a kind of localization to determine which of the antennas is closest to a detected object.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

### LIST OF REFERENCE SIGNS

- 100: NFC device
- 102: NFC reader (PCD/Poller)
- 104: matching circuit
- 106: NFC antenna 1
- 108: NFC antenna 2
- 110: switch
- 112: switch
- 200: method of operating an NFC device
- 202: start
- 204: enter LPCD using NFC antenna 1
- 206: wake-up or exit (u)LPCD
- 208: wake-up?
- 210: enter normal operation using NFC antenna 1
- 212: enter LPCD using NFC antenna 2
- 214: wake-up or exit (u)LPCD
- 216: wake-up
- 218: enter normal operation using NFC antenna 2
- 300: NFC device
- 302: NFC circuit
- 304: matching circuit
- 306: first antenna
- 308: second antenna
- 310: first switch
- 400: method of implementing an NFC device
- 402: providing an NFC device with an NFC circuit
- 404: providing the NFC device with a matching circuit operatively coupled to the NFC circuit
- 406: providing the NFC device with a first antenna and a second antenna
- 408: providing the NFC device with a first switch operable in a first state and in a second state, said first switch being configured to connect a first end of the first antenna to a first end of the second antenna when operated in the first state, and to connect said first end of the first antenna to the matching circuit when operated in the second state
- 500: NFC device
- 502: NFC reader (PCD/Poller)
- 504: matching circuit
- 506: NFC antenna 1
- 508: NFC antenna 2
- 510: first switch
- 512: tuning capacitor
- 514: second switch
- 516: third switch
- 600: method of operating an NFC device
- 602: start
- 604: enter LPCD using both antennas
- 606: wake-up?
- 608: measure loading on NFC antenna 1
- 610: measure loading on NFC antenna 2
- 612: is any of the NFC antennas loaded?
- 614: check which antenna is more loaded
- 616: enter normal operation using NFC antenna 1
- 618: enter normal operation using NFC antenna 2

## Claims

1. A near field communication, NFC, device, comprising:
an NFC circuit;
a matching circuit operatively coupled to the NFC circuit;
a first antenna and a second antenna;
a first switch operable in a first state and in a second state, said first switch being configured to connect a first end of the first antenna to a first end of the second antenna when operated in the first state, and to connect said first end of the first antenna to the matching circuit when operated in the second state.

2. The NFC device of claim 1, further comprising a tuning capacitor coupled between the first end of the first antenna and the first end of the second antenna, such that the first antenna is matched with the second antenna when the first switch is operated in the first state.

3. The NFC device of claim 1 or 2, further comprising a second switch operable in a first state and in a second state, said second switch being configured to connect a second end of the first antenna to the matching circuit when operated in the first state, and to connect the first switch to the matching circuit when operated in the second state.

4. The NFC device of claim 3, further comprising a third switch operable in a first state and in a second state, said third switch being configured to connect a second end of the second antenna to the matching circuit when operated in the first state, and to connect the first end of the first antenna to the matching circuit when operated in the second state.

5. The NFC device of claim 4, further comprising a switching controller configured to control the first switch, the second switch and the third switch in such a way that the second switch is operated in the first state and the third switch is operated in the first state when the first switch is operated in the first state.

6. The NFC device of claim 5, wherein the switching controller is further configured to control the first switch, the second switch and the third switch in such a way that the second switch and the third switch together alternately connect the first antenna and the second antenna to the matching circuit when the first switch is operated in the first state.

7. The NFC device of any preceding claim, further comprising a main controller configured to measure a first load on the first antenna and a second load on the second antenna, and to select either the first antenna or the second antenna for performing NFC operations in dependence on the measured first load and second load.

8. The NFC device of claim 7, wherein the main controller is configured to select the first antenna if the first load is higher than the second load, and to select the second antenna if the second load is higher than the first load.

9. A charging device comprising the NFC device of any preceding claim.

10. The charging device of claim 9, being a Qi-based charging device.

11. A method of implementing a near field communication, NFC, device, comprising:
providing the NFC device with an NFC circuit;
providing the NFC device with a matching circuit operatively coupled to the NFC circuit;
providing the NFC device with a first antenna and a second antenna;
providing the NFC device with a first switch operable in a first state and in a second state, said first switch being configured to connect a first end of the first antenna to a first end of the second antenna when operated in the first state, and to connect said first end of the first antenna to the matching circuit when operated in the second state.

12. The method of claim 11, further comprising providing the NFC device with a tuning capacitor coupled between the first end of the first antenna and the first end of the second antenna, such that the first antenna is matched with the second antenna when the first switch is operated in the first state.

13. The method of claim 11 or 12, further comprising providing the NFC device with a second switch operable in a first state and in a second state, said second switch being configured to connect a second end of the first antenna to the matching circuit when operated in the first state, and to connect the first switch to the matching circuit when operated in the second state.

14. The method of claim 13, further comprising providing the NFC device with a third switch operable in a first state and in a second state, said third switch being configured to connect a second end of the second antenna to the matching circuit when operated in the first state, and to connect the first end of the first antenna to the matching circuit when operated in the second state.

15. The method of claim 14, further comprising providing the NFC device with a switching controller configured to control the first switch, the second switch and the third switch in such a way that the second switch is operated in the first state and the third switch is operated in the first state when the first switch is operated in the first state.

## Amended claims

### Amended claims in accordance with Rule 137(2) EPC.

1. A near field communication, NFC, device (300, 500), comprising:
an NFC circuit (302, 502);
a matching circuit (304, 504) operatively coupled to the NFC circuit (302, 502);
a first antenna (306, 506) and a second antenna (308, 508);
a first switch (310, 510), a second switch (514) and a third switch (516),
wherein the first switch (310, 510) is operable in a first state and in a second state, said first switch (310, 510) being configured to connect a first end of the first antenna (306, 506) to a first end of the second antenna (308, 508) when operated in the first state, and to connect said first end of the second antenna (308, 508) to the matching circuit (304, 504), through the second switch (514), when operated in the second state;
wherein the second switch (514) is operable in a first state and in a second state, said second switch (514) being configured to connect a second end of the first antenna (306, 506) to the matching circuit (304, 504) when operated in the first state, and to connect the first switch (310, 510) to the matching circuit (304, 504) when operated in the second state;
wherein the third switch (516) is operable in a first state and in a second state, said third switch (516) being configured to connect a second end of the second antenna (308, 508) to the matching circuit (304, 504) when operated in the first state, and to connect the first end of the first antenna (306, 506) to the matching circuit (304, 504) when operated in the second state;
**characterized in that** the NFC device (300, 500) further comprises a switching controller configured to control the first switch (310, 510), the second switch (514) and the third switch (516) in such a way that the second switch (514) is operated in the first state and the third switch (516) is operated in the first state when the first switch (310, 510) is operated in the first state, thereby connecting the first antenna (306, 506) and the second antenna (308, 508) in series to the matching circuit (304, 504);
wherein the NFC device (300, 500) further comprises a tuning capacitor (512) coupled between the first end of the first antenna (306, 506) and the first switch (310, 510), such that the first antenna (306, 506) is matched with the second antenna (308, 508) when the first switch (310, 510) is operated in the first state and the first antenna (306, 506) and the second antenna (308, 508) are connected in series to the matching circuit (304, 504).

2. The NFC device (300, 500) of claim 1, further comprising a main controller configured to measure a first load on the first antenna (306, 506) and a second load on the second antenna (308, 508), and to select either the first antenna (306, 506) or the second antenna (308, 508) for performing NFC operations in dependence on the measured first load and second load.

3. The NFC device (300, 500) of claim 2, wherein the main controller is configured to select the first antenna (306, 506) if the first load is higher than the second load, and to select the second antenna (308, 508) if the second load is higher than the first load.

4. A charging device comprising the NFC device (300, 500) of any preceding claim.

5. The charging device of claim 5, being a Qi-based charging device.

6. A method of implementing a near field communication, NFC, device (300, 500), comprising:
providing the NFC device (300, 500) with an NFC circuit (302, 502);
providing the NFC device (300, 500) with a matching circuit (304, 504) operatively coupled to the NFC circuit (302, 502);
providing the NFC device (300, 500) with a first antenna (306, 506) and a second antenna (308, 508);
providing the NFC device (300, 500) with a first switch (310, 510), a second switch (514) and a third switch (516),
wherein the first switch (310, 510) is operable in a first state and in a second state, said first switch (310, 510) being configured to connect a first end of the first antenna (306, 506) to a first end of the second antenna (308, 508) when operated in the first state, and to connect said first end of the second antenna (308, 508) to the matching circuit (304, 504), through the second switch (514), when operated in the second state;
wherein the second switch (514) is operable in a first state and in a second state, said second switch (514) being configured to connect a second end of the first antenna (306, 506) to the matching circuit (304, 504) when operated in the first state, and to connect the first switch (310, 510) to the matching circuit (304, 504) when operated in the second state;
wherein the third switch (516) is operable in a first state and in a second state, said third switch (516) being configured to connect a second end of the second antenna (308, 508) to the matching circuit (304, 504) when operated in the first state, and to connect the first end of the first antenna (306, 506) to the matching circuit (304, 504) when operated in the second state;
**characterized in that** the method further comprises providing the NFC device (300, 500) with a switching controller configured to control the first switch (310, 510), the second switch (514) and the third switch (516) in such a way that the second switch (514) is operated in the first state and the third switch (516) is operated in the first state when the first switch (310, 510) is operated in the first state, thereby connecting the first antenna (306, 506) and the second antenna (308, 508) in series to the matching circuit (304, 504); and
wherein the method further comprises providing the NFC device (300, 500) with a tuning capacitor (512) coupled between the first end of the first antenna (306, 506) and the first switch (310, 510), such that the first antenna (306, 506) is matched with the second antenna (308, 508) when the first switch (310, 510) is operated in the first state and the first antenna (306, 506) and the second antenna (308, 508) are connected in series to the matching circuit (304, 504).
